# EUROPÄISCHE PATENTSCHRIFT

(11) **EP 4 584 212 B1**
(45) Veröffentlichungstag und Bekanntmachung des Hinweises auf die Patenterteilung: **29.07.2026**
(21) Anmeldenummer: 23762434.1
(22) Anmeldetag: 29.08.2023
(51) Int. Cl.: B81C 1/00, G02B 26/08

(54) **MIKROELEKTROMECHANISCHE VORRICHTUNG**
MICRO-ELECTROMECHANICAL DEVICE
MICRODISPOSITIF ÉLECTROMÉCANIQUE

(30) Priorität: 09.09.2022 DE 102022209451
(43) Veröffentlichungstag der Anmeldung: 16.07.2025
(73) Patentinhaber: Robert Bosch GmbH, 70469 Stuttgart (DE); Carl Zeiss SMT GmbH, 73447 Oberkochen (DE)
(72) Erfinder: NOLTEMEYER, Ralf, 71083 Herrenberg (DE); KAELBERER, Arnd, 73278 Schlierbach, DE (DE); STAHL, Heiko, 72760 Reutlingen, DE (DE); HENN, Tobias, 70374 Stuttgart, DE (DE); STIEDL, Jan, 72124 Pliezhausen, DE (DE)
(74) Vertreter: Hörschler, Wolfram Johannes
(86) Internationale Anmeldenummer: PCT/EP2023/073655
(87) Internationale Veröffentlichungsnummer: WO 2024/052168

(56) Entgegenhaltungen:
- WO-A1-2022/112037
- WO-A2-2012/037536
- US-A1- 2019 290 243

## Beschreibung

Die vorliegende Erfindung bezieht sich auf das Gebiet der mikroelektromechanischen Vorrichtungen, insbesondere der Mikrospiegel-Arrays und betrifft eine mikroelektromechanische Vorrichtung, eine Beleuchtungsoptik, ein Beleuchtungssystem für eine Projektionsbelichtungsanlage, eine entsprechende Projektionsbelichtungsanlage sowie ein Verfahren zur Herstellung einer mikroelektromechanischen Vorrichtung.

### Stand der Technik

Der Einsatz von Vorrichtungen mit matrixförmig angeordneten verlagerbaren Mikrospiegeln, sogenannte Mikrospiegel-Arrays oder Mikrospiegelaktoren, erfolgt heutzutage in einer Vielzahl von Vorrichtungen, beispielsweise in Smartphones, Projektoren, Head-up-Displays, Barcodelesern, Maskenbelichtern in der Halbleiterfertigung und Mikroskopen. Entsprechende Mikrospiegel-Arrays sind beispielsweise aus den Schriften DE 10 2013 208 446 A1, EP 0 877 272 A1 und WO 2010/049076 A2 bekannt. Offenbarungen bezüglich geeigneter Aktuator-Einrichtungen zur Verlagerung der Einzelspiegel eines Mikrospiegel-Arrays, der Mikrospiegel, zeigen beispielsweise die DE 10 2013 206 529 A1, die DE 10 2013 206 531 A1 und die DE 10 2015 204 874 A1. Weiterer Stand der Technik ist aus folgenden Dokumenten bekannt:
Dokument WO 2012/037536 A2 beschreibt eine Vorrichtung die über eine integrierte Schaltung verfügt. Eine mikroelektromechanische Schicht mit einem oszillierenden Teil ist mit dem Hauptteil der integrierten Schaltung verbunden. Die mikroelektromechanische Schicht ist auf die integrierte Schaltung aufgebracht.

Dokument WO 2022/112037 A1 beschreibt ein mikroelektromechanisches System das über einen MEMS-Wafer verfügt, der eine Anordnung von MEMS-Elementen umfasst. Jedes MEMS-Element umfasst mehrere Aktuatoren zum Verschieben des MEMS-Elements. Die Anordnung umfasst mehrere Unteranordnungen von MEMS-Elementen. Jede Unteranordnung umfasst mehrere MEMS-Elemente. Ein Steuerwafer umfasst eine Steuerschaltung zum Steuern der MEMS-Elemente.

Ferner beschreibt Dokument US 2019/290243 A1 Eine Wandlerbaugruppe die folgende Elemente umfasst: einen mikroelektromechanischen Systemchip (MEMS-Chip) mit einer Vielzahl von piezoelektrischen Elementen; einen komplementären Metalloxid-Halbleiterchip (CMOS-Chip), der über eine erste Vielzahl von Kontaktstellen elektrisch mit dem MEMS-Chip verbunden ist und mindestens eine Schaltung zum Steuern der Vielzahl von piezoelektrischen Elementen umfasst; und ein Gehäuse, das über eine Klebeschicht am CMOS-Chip befestigt und elektrisch mit dem CMOS-Chip verbunden ist.

### Offenbarung der Erfindung

Erfindungsgemäß werden eine mikroelektromechanische Vorrichtung gemäss Anspruch 1, eine Beleuchtungsoptik umfassend eine solche mikroelektromechanische Vorrichtung sowie ein Beleuchtungssystem und eine Projektionsbelichtungsanlage, jeweils mit einer entsprechenden Beleuchtungsoptik, sowie ein Verfahren nach Anspruch 9 zur Herstellung einer erfindungsgemäßen mikroelektromechanischen Vorrichtung vorgeschlagen.

Gemäß einem ersten Aspekt der Erfindung wird eine mikroelektromechanische Vorrichtung umfassend ein Trägersubstrat mit einer Substratoberfläche und mehrere MEMS-Module vorgeschlagen (MEMS: microelectromechanical system). Hierbei umfasst jedes der mehreren MEMS-Module eine, vorzugsweise genau eine ASIC-Schicht mit einer ASIC-Schicht-Vorderseite und einer dieser ASIC-Schicht-Vorderseite gegenüberliegenden ASIC-Schicht-Rückseite, eine Grundplatte mit einer Grundplattenvorderseite und einer dieser Grundplattenvorderseite gegenüberliegenden Grundplattenrückseite und mehrere mikroelektromechanische Bauelemente mit einer Bauelementrückseite. Die mikroelektromechanischen Bauelemente müssen nicht identisch von ihrem Aufbau und/oder ihrer Funktion sein, dies kann allerdings der Fall sein. Die Grundplatte ist auf der ASIC-Schicht-Vorderseite angeordnet und die Grundplattenrückseite mit der ASIC-Schicht-Vorderseite über elektrische Kontakte stoffschlüssig verbunden. Hierfür kommt insbesondere eine stoffschlüssige Verbindung mittels Löten oder vorzugsweise Sintern oder eutektischem Bonden in Frage. Als Sintermaterial kann beispielsweise Silbersinterpaste eingesetzt werden. Die mehreren mikroelektromechanischen Bauelemente sind weiterhin auf der Grundplattenvorderseite angeordnet und deren Bauelementrückseiten mit der Grundplattenvorderseite verbunden. Hierbei sind die elektrischen Kontakte zwischen Grundplatte und ASIC-Schicht zumindest teilweise, vorzugsweise alle durch mindestens einen zwischen Grundplatte und ASIC-Schicht angeordneten Schutzrahmen umfasst, der ebenfalls elektrisch leitfähig sein kann. Hierbei ist eine Umsetzung mit mehreren Schutzrahmen in einem MEMS-Modul denkbar, wobei in so einem Fall jeder dieser Schutzrahmen einen anderen Teil der elektrischen Kontakte zwischen Grundplatte und ASIC-Schicht umfasst, vorzugsweise handelt es sich aber nur um genau einen Schutzrahmen je MEMS-Modul. Die ASIC-Schicht jedes der MEMS-Module weist ein oder mehrere ASICs (application-specific integrated circuit) zum Ansteuern der mehreren mikroelektromechanischen Bauelemente auf, wobei das eine oder die mehreren ASICs mit den mikroelektromechanischen Bauelementen unter Benutzung zumindest eines Teils der elektrischen Kontakte elektrisch verbunden sind, wobei die elektrischen Kontakte typischerweise in den Grundplatten zu den mikroelektromechanischen Bauelemente mittels elektrischer Verbindungen, beispielsweise Durchkontaktierungen, weitergeführt sind. Beispielsweise kann zur Herstellung von elektrischen Verbindungen zwischen einer auf dem Trägersubstrat befindlichen weiteren Elektronik und den mikroelektromechanischen Bauelementen die ASIC-Schicht neben ASICs optional auch Verdrahtungsträger (Interposer) und/oder weitere Elemente umfassen. Eine ASIC-Schicht eines MEMS-Moduls kann eine durchgängige ASIC-Schicht oder eine nicht durchgängige ASIC-Schicht sein. Der Begriff der Durchgängigkeit einer ASIC-Schicht meint, dass alle Elemente der ASIC-Schicht über die Schicht selbst mechanisch miteinander verbunden sind. Eine solche mechanische Verbindung über die ASIC-Schicht zwischen zwei Elementen kann durch die Elemente selbst und/oder durch andere Elemente der Schicht, wie beispielsweise ASICs, Verdrahtungsträger, geeignete Verbindungselemente, Füllmaterialien und/oder Fügematerialien, erfolgen. Im Fall einer nicht durchgängigen ASIC-Schicht weist diese Schicht Elemente wie beispielsweise ASICS und/oder Interposer auf, die nicht über die Schicht selbst mechanisch miteinander verbunden sind. Die ASIC-Schicht weist folglich eine Lücke auf. Elektrische Verbindungen können mittels der elektrischen Kontakte zwischen ASIC-Schicht und Grundplatte weitergeführt werden. Als Interposer kommen insbesondere siliziumbasierte Interposer mit elektrischen Verbindungen, beispielsweise Silizium-Durchkontaktierungen (TSV, through-silicon via) wie beispielsweise kupferbasierte Durchkontaktierungen (Cu vias), in Frage. Die mehreren MEMS-Module sind auf der Substratoberfläche des Trägersubstrats angeordnet und die ASIC-Schicht-Rückseiten der mehreren MEMS-Module mit der Substratoberfläche verbunden. Auch diese Verbindung ist typischerweise stoffschlüssig ausgeführt und erfolgt vorzugsweise durch Sintern. Bei der weiteren Elektronik auf dem Trägersubstrat kann es sich beispielsweise um weitere ASICs zur Ansteuerung der gesamten elektromechanischen Vorrichtung, um passive Bauelemente und/oder Verbindungselemente (wie Stecker, Kabel), beispielsweise zum Herstellen einer elektrischen Verbindung zu externen Steuergeräten wie einer Recheneinheit sowie zur Stromversorgung handeln. Das Trägersubstrat dient insgesamt als Bauteilträger und kann elektrische Verbindungen, beispielsweise Durchkontaktierungen zur Durchleitung von elektrischen Signalen von einer Oberfläche des Trägersubstrats zu einer anderen Oberfläche des Trägersubstrats umfassen. So kann es beispielsweise vorteilhaft sein, die weitere Elektronik auf einer Substratoberfläche des Trägersubstrats anzuordnen, die der Substratoberfläche mit den MEMS-Modulen gegenüberliegt. Das Trägersubstrat kann beispielsweise im Wesentlichen aus einer Keramik, beispielsweise einer Al₂O₃-basierten Keramik, bestehen.

Eine solche mikroelektromechanische Vorrichtung gliedert folglich ihre Mehrzahl an mikroelektromechanischen Bauelementen in einzelne Gruppen, die jeweils mehrere mikroelektromechanische Bauelemente umfassen und im Rahmen dieser Erfindung als MEMS-Module bezeichnet werden. Die mehreren MEMS-Module können beispielsweise jeweils genau 2, 3, 4, 5, 6, 9, 12, 16, 20, 25, 30, 36, 42, 49, 56, 64, 72 oder 81 der mehreren mikroelektromechanischen Bauelemente aufweisen, wobei auch andere Anzahlen ≥ 2 denkbar sind. Die mehreren mikroelektromechanischen Bauelemente können beispielsweise in einem rechteckigen Raster bestehend aus Spalten und Reihen angeordnet sein, beispielsweise bestehend zwei Spalten und zwei Reihen, zwei Spalten und drei Reihen, drei Spalten und drei Reihen, drei Spalten und vier Reihen, vier Spalten und vier Reihen, vier Spalten und fünf Reihen, fünf Spalten und fünf Reihen, fünf Spalten und sechs Reihen, sechs Spalten und sechs Reihen, sechs Spalten und sieben Reihen, sieben Spalten und sieben Reihen, sieben Spalten und acht Reihen, acht Spalten und acht Reihen, acht Spalten, und neun Reihen oder neun Spalten und neun Reihen. Alternativ ist beispielsweise ein sechseckiges Raster denkbar. Eine erfindungsgemäße elektromechanische Vorrichtung kann beispielsweise genau 2, 3, 4, 5, 6, 9, 12, 16, 20, 25, 30, 36, 42, 49, 56, 64, 72 oder 81 MEMS-Module umfassen, wobei auch andere Anzahlen ≥ 2 denkbar sind. Auch die MEMS-Module können in einem rechteckigen Raster bestehend aus Spaten und Reihen angeordnet sein, beispielsweise bestehend zwei Spalten und zwei Reihen, zwei Spalten und drei Reihen, drei Spalten und drei Reihen, drei Spalten und vier Reihen, vier Spalten und vier Reihen, vier Spalten und fünf Reihen, fünf Spalten und fünf Reihen, fünf Spalten und sechs Reihen, sechs Spalten und sechs Reihen, sechs Spalten und sieben Reihen, sieben Spalten und sieben Reihen, sieben Spalten und acht Reihen, acht Spalten und acht Reihen, acht Spalten, und neun Reihen oder neun Spalten und neun Reihen. Auch hier ist alternativ beispielsweise ein sechseckiges Raster denkbar.

Ein vorteilhafter Aspekt einer so gegliederten mikroelektromechanischen Vorrichtung ist, dass durch die Gliederung in MEMS-Module eine Reduzierung der Komplexität und Fehleranfälligkeit des Aufbaus erreicht wird. Es wurde festgestellt, dass mehrere MEMS-Module mit einer reduzierten Anzahl von mikroelektromechanischen Bauelementen im Produktionsprozess einfacher zu handhaben sind als eine einzelne Einheit mit derselben Gesamtzahl von mikroelektromechanischen Bauelementen. Insbesondere kann durch einen erfindungsgemäßen Ansatz die Ausbeute des Produktionsprozesses deutlich gesteigert werden, da bei der Produktion gezielt die MEMS-Module ausgewählt werden können, die ausschließlich voll funktionsfähige mikroelektromechanische Bauelemente beinhalten. Weiterhin ist vorstellbar, dass eine Vielzahl solcher erfindungsgemäßen mikroelektromechanischen Vorrichtungen wiederum zu einer übergeordneten Einheit verbunden werden, beispielsweise um größere Flächen abzudecken als mit einer einzelnen erfindungsgemäßen mikroelektromechanischen Vorrichtung praktikabel. Die erfindungsgemäß zwischen den Grundplatten und den ASIC-Schichten angeordneten Schutzrahmen sorgen dafür, dass in den durch die Schutzrahmen umgebenden Bereichen keine Beschädigungen auftreten können. Insbesondere werden so die in diesen Bereichen liegenden Strukturen der ASICs und die elektrischen Kontakte vor Schäden und Verunreinigungen geschützt, wie sie bei der Herstellung einer erfindungsgemäßen mikroelektromechanischen Vorrichtung und auch im späteren Betrieb auftreten können. Die Schutzrahmen dienen also zur Abkapselung von der Umwelt. Gleichzeitig wird auch der mechanische Zusammenhalt zwischen ASIC-Schichten und Grundplatten erhöht. Vorzugsweise sind die Schutzrahmen der MEMS-Module so ausgeführt, dass insbesondere temperaturbedingte Verformungen der MEMS-Module reduziert werden.

Die Schutzrahmen sind weiterhin vorzugsweise so gestaltet, dass sie die gesamte ASIC-Schicht-Oberseite und die gesamte Grundplattenunterseite umfassen oder selbst bedecken. Die Schutzrahmen erstrecken sich folglich vorzugsweise entlang der Ränder der ASIC-Schicht-Oberseite und der Grundplattenunterseite. Bevorzugt steht dabei ein Schutzrahmen eines MEMS-Moduls nicht über die Grundplatte seitlich hinaus, um eine möglichst dichte Anordnung der MEMS-Module auf einem Trägersubstrat, also einen hohen Füllfaktor, zu ermöglichen. Ebenfalls zur Ermöglichung eines hohen Füllfaktors steht vorzugsweise auch die ASIC-Schicht eines MEMS-Moduls nicht seitlich über die Grundplatte hinaus. Die ASIC-Schicht eines MEMS-Moduls besitzt folglich vorzugsweise zur Grundplatte identische oder geringere Abmessungen. Ein besonders wichtige Ausführungsform der Erfindung ist der Einsatz mit Mikrospiegeln als mikroelektromechanische Bauelemente. Die mikroelektromechanische Vorrichtung kann also insbesondere ein Mikrospiegel-Array sein. In einem solchen Fall umfasst jedes der mehreren mikroelektromechanischen Bauelemente ein Spiegelelement mit einer Reflexionsfläche zur Reflexion von Licht und eine Verlagerungseinrichtung zum Verlagern des Spiegelelements des jeweiligen mikroelektromechanischen Bauelements, wobei das eine oder die mehreren ASICs zum Ansteuern der Verlagerungseinrichtungen ausgebildet sind. Hierbei meint ein Verlagern eine Bewegung im Hinblick auf zumindest einen Freiheitsgrad. Ein Verlagern kann sowohl lineare Bewegungen als auch Drehungen umfassen. Das Spiegelelement kann insbesondere ein Bragg-Spiegel sein oder seinen solchen umfassen. Bei den Verlagerungseinrichtungen kann es sich beispielsweise um elektrostatische Aktuatoren, beispielsweise mit Kammelektroden, handeln. In Frage kommen beispielsweise Aktuatoren wie in den Dokumenten DE 10 2013 206 529 A1, DE 10 213 206 531 A1 und DE 10 2015 204 874 A1 beschrieben.

Weiterhin ist es besonders vorteilhaft, wenn jedes der mehreren mikroelektromechanisches Bauelemente von jedem der mehreren MEMS-Module eine im Wesentlichen rechteckige, vorzugsweise quadratische oder eine im Wesentlichen sechseckige Grundfläche besitzt. Im Wesentlichen rechteckige beziehungsweise sechseckige Grundfläche, dass kleinere Abweichungen von einer rechteckigen beziehungsweise sechseckigen Grundfläche denkbar sind, beispielsweise durch abgerundete Ecken und/oder Ein- oder Ausbuchtungen.

Gemäß einer bevorzugten Ausgestaltung der Erfindung ist der mindestens eine Schutzrahmen von jedem der mehreren MEMS-Module ein Teil der stoffschlüssigen Verbindung der Grundplattenrückseite mit der ASIC-Schicht-Vorderseite in dem jeweiligen der mehreren MEMS-Module. Dies ermöglicht es, die Schutzrahmen einer erfindungsgemäßen Vorrichtung besonders einfach in einem Produktionsprozess zu realisieren.

Um die MEMS-Module während des Produktionsprozesses auf der Substratoberfläche platzieren, also greifen, bewegen und/oder positionieren zu können, beispielsweise mittels einer geeigneten Maschine, müssen die MEMS-Module ergriffen werden können, ohne diese zu beschädigen. Hierzu können die MEMS-Module jeweils einen das MEMS-Modul seitlich begrenzenden Rahmen umfassen, an dem ein MEMS-Modul ergriffen und anschließend bewegt und/oder positioniert werden kann. Dieser Rahmen kann mit einem Schutzrahmen des jeweiligen MEMS-Moduls identisch sein, ist dies bevorzugt aber nicht.

Gemäß einem zweiten Aspekt der Erfindung wird eine Beleuchtungsoptik für eine mikroelektromechanische Vorrichtung zur Führung von Beleuchtungsstrahlung zu einem Objektfeld vorgeschlagen, die mindestens eine erfindungsgemäße mikroelektromechanische Vorrichtung umfasst, wobei jedes der mehreren mikroelektromechanischen Bauelemente ein Spiegelelement mit einer Reflexionsfläche und eine Verlagerungseinrichtung zum Verlagern des Spiegelelements des jeweiligen mikroelektromechanisches Bauelements umfasst, wobei das eine oder die mehreren ASICs zum Ansteuern der Verlagerungseinrichtungen ausgebildet sind. Eine erfindungsgemäße Beleuchtungsoptik setzt also eine erfindungsgemäße mikroelektromechanische Vorrichtung als Mikrospiegel-Array ein. Sie kann insbesondere auch mehrere solcher erfindungsgemäßer Mikrospiegel-Arrays umfassen, beispielsweise, um mit einer Anordnung dieser Vielzahl von Mikrospiegel-Arrays einen größeren Gesamt-Mikrospiegel-Array umzusetzen mit dem es ermöglicht wird, einfallende Lichtstrahlen mit einem größeren Strahldurchmesser umzulenken.

Es wird gemäß einem dritten Aspekt auch ein Beleuchtungssystem für eine Projektionsbelichtungsanlage vorgeschlagen, das eine erfindungsgemäße Beleuchtungsoptik und eine Strahlungsquelle, insbesondere eine EUV-Strahlungsquelle, umfasst.

Gemäß einem vierten Aspekt wird eine Projektionsbelichtungsanlage für die Mikrolithographie vorgeschlagen, die eine erfindungsgemäße Beleuchtungsoptik und eine Projektionsoptik zur Projizierung eines in einem Objektfeld angeordneten Retikels in ein Bildfeld umfasst.

Eine erfindungsgemäße Beleuchtungsoptik, ein erfindungsgemäßes Beleuchtungssystem und eine erfindungsgemäße Projektionsbelichtungsanlage können Teil einer EUV-Lithographie-Anlage sein. Für solche sind verstellbare optische Pfade bis zu einer Fotomaske (auch als Retikel bezeichnet) vorteilhaft, die durch ein Mikrospiegel-Array als erfindungsgemäße mikroelektromechanische Vorrichtung im optischen Pfad verwirklicht werden kann. Die Reflexionsflächen der Spiegelelemente können mit einer Bragg-Beschichtung versehen sein, die die Zentralwellenlängen des zur Belichtung eingesetzten Lichts besonders gut reflektiert.

Für weitere Details bezüglich eines möglichen allgemeinen Aufbaus einer entsprechenden Projektionsbelichtungsanlage und einer zugehörigen Beleuchtungsoptik und eines zugehörigen Beleuchtungssystems sei auf die DE 10 2015 204 874 A1 und die DE 10 2016 213 026 A1 verwiesen, die hiermit vollständig als Bestandteil der vorliegenden Anmeldung in diese integriert sind.

Gemäß einem fünften Aspekt der Erfindung ist ein Verfahren zur Herstellung einer mikroelektromechanischen Vorrichtung, vorzugsweise gemäß dem ersten Aspekt der Erfindung, umfassend ein Trägersubstrat und mehrere MEMS-Module vorgesehen. Jedes der MEMS-Module umfasst eine, vorzugsweise genau eine ASIC-Schicht mit einem oder mehreren ASIC (und optional auch anderen Elementen wie einem oder mehreren Interposern) und einer ASIC-Schicht-Vorderseite und einer ASIC-Schicht-Rückseite, eine Grundplatte mit einer Grundplattenvorderseite und einer Grundplattenrückseite und mehrere mikroelektromechanische Bauelemente umfasst, wobei die Grundplatte auf der ASIC-Schicht-Vorderseite angeordnet und die Grundplattenrückseite mit der ASIC-Schicht-Vorderseite verbunden ist. Die ASICs-Schichten der MEMS-Module können als durchgängige ASIC-Schichten oder als nicht durchgängige ASIC-Schichten ausgebildet sein. Gemäß dem erfindungsgemäßen Verfahren erfolgt ein Bereitstellen eines MEMS-Substrats mit Strukturen für die mikroelektromechanischen Bauelemente und die Grundplatten der mehreren MEMS-Module. Das bereitgestellte MEMS-Substrat umfasst folglich Strukturen für die mikroelektromechanischen Bauelemente und für die Grundplatten der mehreren MEMS-Module. Ein solches Substrat liegt typischerweise in der Form eines Wafers vor (MEMS-Wafer) und kann beispielsweise mittels eines Verfahrens wie in der DE10 2015 206 996 A1 beschrieben hergestellt werden. Ebenso erfolgt ein Bereitstellen eines ASIC-Substrats mit Strukturen für die ASIC-Schichten der mikroelektromechanischen Vorrichtung, ebenfalls typischerweise in Form eines Wafers (ASIC-Wafer). Aus diesen beiden Substraten wird ein gekoppeltes Substrat, typischerweise in Form eines gekoppelten Wafers, durch Verbinden (im Fall von Wafern: Waferbonden), insbesondere stoffschlüssigem Verbinden (beispielsweise Löten, Sintern, beispielsweise mit einer Silbersinterpaste, oder eutektischem Bonden), hergestellt, wobei für jedes der mehreren MEMS-Modul mehrere zugeordnete elektrische Kontakte und mindestens ein, vorzugsweise genau ein zugeordneter Schutzrahmen zwischen MEMS-Substrat und ASIC-Substrat ausgebildet werden, so dass für jedes MEMS-Modul der dem MEMS-Modul mindestens eine zugeordnete Schutzrahmen die dem MEMS-Modul zugeordneten elektrischen Kontakte zumindest teilweise, vorzugsweise alle umfasst. Anschließend wird dieses gekoppelte Substrat entlang vorgegebener Trennlinien, beispielsweise entlang einer Gitterstruktur, vereinzelt um die mehreren MEMS-Module zu erhalten, beispielsweise mittels Sägen durch eine Säge oder Schneidens durch einen Laserstrahl. Eine Vereinzelung kann auch unter Verwendung eines Ätzverfahrens wie reaktivem lonentiefätzen (DRIE, deep reactive ion etching) erfolgen. Die Schutzrahmen schützen in diesem Verfahrensschritt den Bereich der Kontakte vor Verunreinigungen und eventuellen Schäden sowie die dort liegenden Strukturen der jeweiligen ASIC-Schicht. Außerdem sorgen die Schutzrahmen für einen verbesserten Zusammenhalt des gekoppelten Substrats vor und während des Vereinzelns sowie nach der Vereinzelung der MEMS-Module.

Weiterhin wird ein Trägersubstrat bereitgestellt, auf dem gegebenenfalls bereits weitere Elektronik und/oder andere Komponenten angebracht sein kann. Die mehreren MEMS-Module werden auf einer Substratoberfläche des Trägersubstrats platziert. Anschließend erfolgt ein stoffschlüssiges Verbinden, beispielsweise mittels Löten oder Sintern, beispielsweise mit einer Silbersinterpaste, der ASIC-Schicht-Rückseiten der mehreren MEMS-Module mit der Substratoberfläche. Vorzugsweise erfolgt vor dem Herstellen des gekoppelten Substrats ein Testen der mikroelektromechanischen Strukturen des MEMS-Substrats und/oder ein Testen der Strukturen des ASIC-Substrats um die Funktionsfähigkeit sicherzustellen. Vorzugsweise kann zur Sicherstellung der Funktionsfähigkeit auch ein Testen der MEMS-Module nach dem Herstellen des gekoppelten Substrats und/oder der gesamten fertiggestellten mikroelektromechanischen Vorrichtung nach dem stoffschlüssigen Verbinden der ASIC-Schicht-Rückseiten der mehreren MEMS-Module mit der Substratoberfläche erfolgen.

### Vorteile der Erfindung

Die Erfindung bietet einen Ansatz für mikroelektromechanische Vorrichtungen wie beispielsweise Mikrospiegel-Arrays, die eine Mehrzahl von mikroelektromechanischen Bauelemente umfassen, die auf demselben Trägersubstrat angeordnet sind.

Durch die erfindungsgemäße Gliederung der mikroelektromechanischen Bauelemente in einzelne kleinere Einheiten (MEMS-Module) kann insbesondere die Ausbeute des Produktionsprozesses deutlich gesteigert werden, da bei der Produktion die einzelnen MEMS-Module gezielt getestet und anschließend die ausgewählt werden können, die ausschließlich voll funktionsfähige mikroelektromechanische Bauelemente beinhalten. Weiterhin wird durch den Einsatz von Schutzrahmen zur Umfassung wichtiger Bereiche der MEMS-Module einschließlich relevanter elektrischer Kontakte ein Schutz vor Beschädigungen und Verunreinigungen erreicht werden, insbesondere im Verlauf des erfindungsgemäßen Herstellungsverfahrens während der für die Fertigung der MEMS-Module erforderlichen Vereinzelung und bei dem Einsatz des MEMS-Moduls in einer aggressiven Umgebung. Solche Schutzrahmen erhöhen weiterhin auch die mechanische Stabilität der Verbindung zwischen MEMS-Substrat und ASIC-Substrat.

### Kurze Beschreibung der Zeichnungen

Ausführungsformen der Erfindung werden anhand der Zeichnungen und der nachfolgenden Beschreibung näher erläutert.

Es zeigen:
- Figur 1: eine schematische Darstellung eines Teils einer beispielhaften erfindungsgemäßen mikroelektromechanischen Vorrichtung in einer Seitenansicht;
- Figur 2: eine schematische Darstellung eines MEMS-Moduls einer zweiten beispielhaften erfindungsgemäßen mikroelektromechanischen Vorrichtung in einer Seitenansicht sowie eine schematische Ansicht zur Verdeutlichung der Anordnung eines Schutzrahmens; und
- Figur 3: in schematischer Form als Flussdiagramm ein erfindungsgemäßes Verfahren zur Herstellung einer mikroelektromechanischen Vorrichtung.

### Ausführungsformen der Erfindung

In der nachfolgenden Beschreibung der Ausführungsformen der Erfindung werden gleiche oder ähnliche Elemente mit gleichen Bezugszeichen bezeichnet, wobei auf eine wiederholte Beschreibung dieser Elemente in Einzelfällen verzichtet wird. Die Figuren stellen den Gegenstand der Erfindung nur schematisch dar.

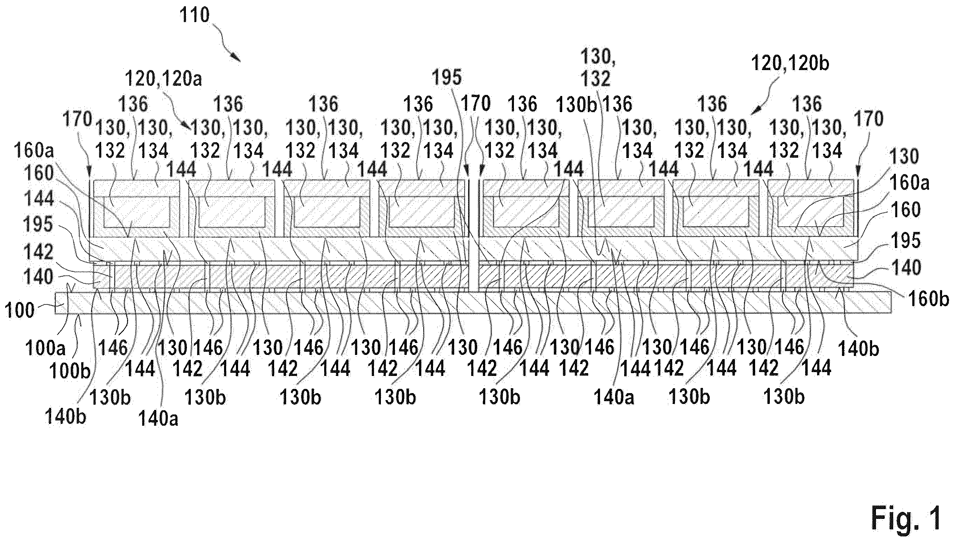

Figur 1 zeigt eine schematische Darstellung eines Teils einer beispielhaften erfindungsgemäßen mikroelektromechanischen Vorrichtung 110, eines Mikrospiegel-Arrays, von der Seite. Auf der Substratoberfläche 100a eines Trägersubstrat 100 sind im dargestellten Beispiel zwei MEMS-Module 120 (linkes MEMS-Modul: 120a, rechtes MEMS-Modul: 120b) angeordnet, die jeweils mehrere mikroelektromechanische Bauelemente 130 umfassen, wovon in der Figur 1 jeweils vier dargestellt sind. Bei den mikroelektromechanischen Bauelementen 130 handelt es sich im gezeigten Fall um Mikrospiegel. Diese umfassen jeweils ein Spiegelelement 134, das wiederum über eine Reflexionsfläche 136 zur Reflexion von Licht verfügt. Diese Spiegelelemente 134 können durch Verlagerungseinrichtungen 132 bewegt werden. Zum Ansteuern der Verlagerungseinrichtungen 132 dienen ASICs, die in Form von Dies unterhalb der Verlagerungseinrichtungen 132 in ASIC-Schichten 140 angeordnet sind und ebenfalls Teil des jeweiligen MEMS-Moduls 120 sind. Weitere Elektronik, zum Beispiel ebenfalls zur Steuerung der Verlagerungseinrichtungen 132, beispielsweise in Form weiterer ASICs, kann beispielsweise auf der Rückseite 100b des Trägersubstrats 100 angeordnet sein (nicht dargestellt).

Innerhalb eines MEMS-Moduls 120 sind die mikroelektromechanischen Bauelemente 130 auf der Vorderseite 160a einer Grundplatte 160 angeordnet. Hierbei ist diese Grundplattenvorderseite 160a mit den Rückseiten 130b der mikroelektromechanischen Bauelemente 130 verbunden. In dem dargestellten Beispiel sind zwei Grundplatten 160 sichtbar, auf denen sich die jeweils vier sichtbaren mikroelektromechanischen Bauelemente 130 befinden. Die mikroelektromechanischen Bauelemente 130 sind über elektrische Kontakte 144 mit den ASICs der jeweiligen ASIC-Schicht 140 verbunden. Die ASICs der ASIC-Schichten 140 wiederum können über elektrische Kontakte 146 mit weiterer Elektronik (nicht dargestellt) verbunden sein, die beispielsweise auf dem Trägersubstrat 100 angeordnet sein kann. Auch können beispielsweise Silizium-Durchkontaktierungen (TSV, through-silicon via) 142 in den ASIC-Schichten 140 existieren, die beispielsweise zur Herstellung von elektrischen Verbindungen zwischen einer solchen weiteren Elektronik auf dem Trägersubstrat 100 und den mikroelektromechanischen Bauelementen 130 dienen können. Solche Durchkontaktierungen 142 können beispielsweise auch mittels Interposer, die ebenfalls Teil der ASIC-Schichten 140 sein können, oder mittels der Dies der ASICs umgesetzt sein.

Weiterhin ist in der Figur 1 für jedes der zwei gezeigten MEMS-Module 120 ein Schutzrahmen 195 sichtbar, der den Bereich zwischen den Grundplatten 160 und der ASIC-Schicht 140 und damit auch die elektrischen Kontakte 144 (elektrische Kontakte zwischen ASICs und Grundplatte sowie elektrische Kontakte als Weiterführungen von Durchkontaktierungen 142) vor Beschädigungen schützt. Weiterhin kann optional jeweils ein weiterer Rahmen 170 Teil der MEMS-Module 120 sein, der die MEMS-Module 120 seitlich begrenzt und mittels dessen die MEMS-Module 120 auf dem Trägersubstrat 100 platziert werden können, ohne Beschädigungen der MEMS-Module 120 und insbesondere deren mikroelektromechanischer Bauelemente 130 zu riskieren beziehungsweise vor Eintrag von Partikeln schützt.

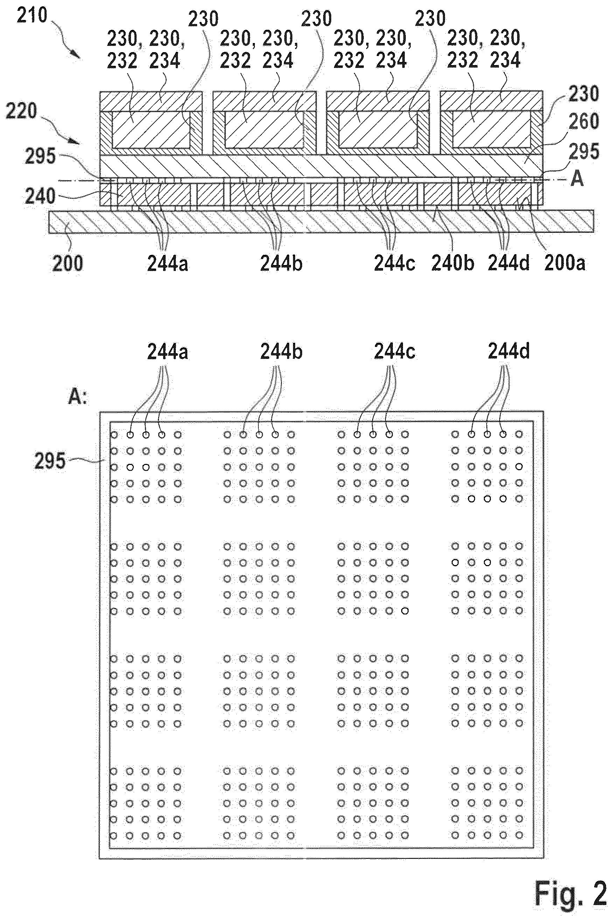

Figur 2 zeigt eine schematische Darstellung eines MEMS-Moduls 220 einer zweiten beispielhaften erfindungsgemäßen mikroelektromechanischen Vorrichtung 210 in einer Seitenansicht in einer oberen Teilfigur sowie eine schematische Ansicht einer Schnittebene A zur Verdeutlichung der Anordnung eines Schutzrahmens 295 im MEMS-Modul 220 in einer unteren Teilfigur. Wie in der Figur 1 besitzt auch das hier dargestellte MEMS-Modul 220 vier in der Seitenansicht der oberen Teilfigur sichtbare mikroelektromechanische Bauelemente 230. Insgesamt verfügt das dargestellte MEMS-Modul 220, wie aus der unteren Teilfigur hervorgeht, über 16 mikroelektromechanische Bauelemente 230 mit je einer Verlagerungseinrichtung 232 zum Verlagern von Spiegelelementen 234 mit Reflexionsflächen. Zwischen einer ASIC-Schicht 240 und der Grundplatte 260 befinden sich elektrische Kontakte 244a, 244b, 244c, 244d, die teilweise Fortführungen von elektrischen Verbindungen wie Durchkontaktierungen 142 in der ASIC-Schicht 240 sind. Zumindest teilweise sind diese elektrischen Kontakte 244a, 244b, 244c, 244d umfasst von einem Schutzrahmen 295. Bevorzugt und wie in Figur 2 gezeigt befinden sich alle elektrischen Kontakte 244a, 244b, 244c, 244d innerhalb des vom Schutzrahmen 295 definierten Bereichs. Das gesamte MEMS-Modul 220 ist auf einem Trägersubstrat 200, beispielsweise im Wesentlichen bestehend aus einer Keramik, angeordnet, wobei die ASIC-Schicht-Rückseite 240b der ASIC-Schicht 240 mit der Substratoberfläche 200a des Trägersubstrats 200 beispielsweise stoffschlüssig verbunden ist.

Die Schnittebene A, die in der Höhe der elektrischen Kontakte 244a, 244b, 244c, 244d liegt, ist in der unteren Teilfigur in einer Draufsicht dargestellt. Erkennbar ist, dass das beispielhafte MEMS-Modul 220 aus vier mal vier mikroelektromechanischen Bauelementen 230 besteht, denen jeweils 25 elektrische Kontakte 244a, 244b, 244c, 244d zugeordnet sind.

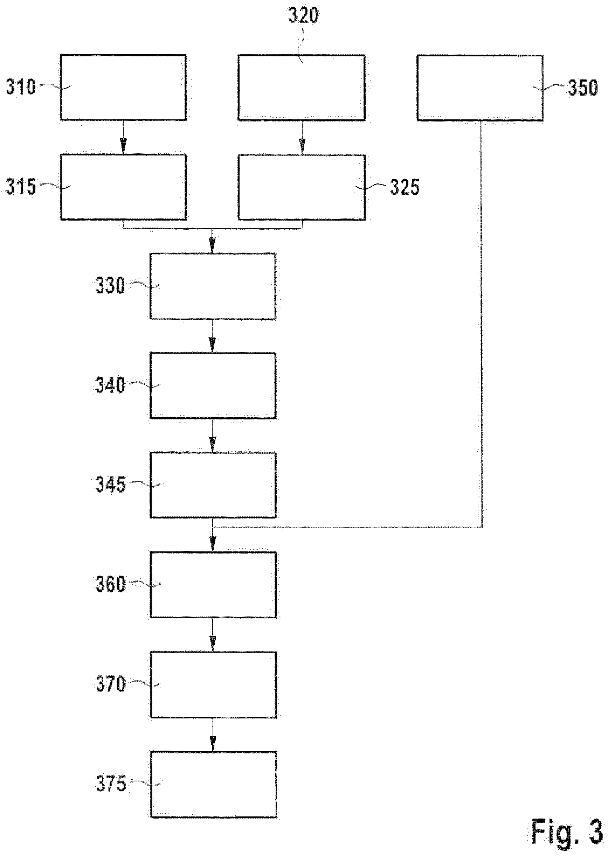

Figur 3 schließlich zeigt in schematischer Form als Flussdiagramm ein erfindungsgemäßes Verfahren zur Herstellung einer mikroelektromechanischen Vorrichtung 110, 210 umfassend ein Trägersubstrat 100, 200 und mehrere MEMS-Module 120, 220, wobei jedes der MEMS-Module 120, 220 eine ASIC-Schicht 140, 240 umfassend ein oder mehrere ASICs mit einer ASIC-Schicht-Vorderseite 140a, 240a und einer ASIC-Schicht-Rückseite 140b, 240b, eine Grundplatte 160, 260 mit einer Grundplattenvorderseite 160a und einer Grundplattenrückseite 160b und mehrere mikroelektromechanische Bauelemente 130, 230 umfasst, wobei die Grundplatte 160, 260 auf der ASIC-Schicht-Vorderseite 140a angeordnet und die Grundplattenrückseite 160b mit der ASIC-Schicht-Vorderseite 140a verbunden ist. Hierbei erfolgt ein Bereitstellen 310 eines MEMS-Substrats mit Strukturen für die mikroelektromechanischen Bauelemente 130, 230 und die Grundplatten 160, 260 der mehreren MEMS-Module 120, 220. Ebenso erfolgt ein Bereitstellen 320 eines ASIC-Substrats mit Strukturen für die ASIC-Schichten 140, 240 der mehreren MEMS-Module 120, 220. Aus diesen wird ein gekoppeltes Substrat durch stoffschlüssiges Verbinden, beispielsweise Löten, Sintern oder eutektischem Bonden, hergestellt, wobei für jedes der mehreren MEMS-Modul 120, 220 mehrere zugeordnete elektrische Kontakte 144 zwischen MEMS-Substrat und ASIC-Substrat ausgebildet werden. Anschließend wird dieses gekoppelten Substrats entlang vorgegebener Trennlinien wie beispielsweise einer Gitterstruktur vereinzelt, um die mehreren MEMS-Module 120, 220 zu erhalten. Weiterhin wird ein Trägersubstrat 100, 200 bereitgestellt, auf dem gegebenenfalls weitere Elektronik angebracht sein kann. Die mehreren MEMS-Module 120, 220 werden auf der Substratoberfläche 100a, 200a des Trägersubstrats 100, 200 platziert. Schließlich werden die ASIC-Schicht-Rückseiten 140b der mehreren MEMS-Module 120, 220 stoffschlüssig in Schritt 370 mit der Substratoberfläche 100a, 200a verbunden.

Vorzugsweise erfolgt vor dem Herstellen des gekoppelten Substrats ein Testen 315 der mikroelektromechanischen Strukturen des MEMS-Substrats und/oder ein Testen 325 der Strukturen des ASIC-Substrats um die Funktionsfähigkeit sicherzustellen. Zusätzlich oder alternativ kann zur Sicherstellung der Funktionsfähigkeit auch ein Testen 345 der MEMS-Module 120, 220 nach dem Herstellen des gekoppelten Substrats und/oder ein Testen 375 der gesamten fertiggestellten mikroelektromechanischen Vorrichtung 110, 210 nach dem stoffschlüssigen Verbinden der ASIC-Schicht-Rückseiten 140b der mehreren MEMS-Module 120, 220 mit der Substratoberfläche 100a erfolgen.

Die Erfindung ist nicht auf die hier beschriebenen Ausführungsbeispiele und die darin hervorgehobenen Aspekte beschränkt. Vielmehr ist innerhalb des durch die Ansprüche angegebenen Bereichs eine Vielzahl von Abwandlungen möglich, die im Rahmen fachmännischen Handelns liegen.

## Patentansprüche

1. Mikroelektromechanische Vorrichtung (110, 210) umfassend ein Trägersubstrat (100, 200) mit einer Substratoberfläche (100a, 200a) und mehrere MEMS-Module (120, 220),
wobei jedes der mehreren MEMS-Module (120, 220) eine ASIC-Schicht (140) mit einer ASIC-Schicht-Vorderseite (140a) und einer ASIC-Schicht-Rückseite (140b), eine Grundplatte (160, 260) mit einer Grundplattenvorderseite (160a) und einer Grundplattenrückseite (160b) und mehrere mikroelektromechanische Bauelemente (130, 230) mit einer Bauelementrückseite (130b) umfasst,
wobei die Grundplatte (160, 260) auf der ASIC-Schicht-Vorderseite (140a) angeordnet und die Grundplattenrückseite (160b) mit der ASIC-Schicht-Vorderseite (140a) über elektrische Kontakte (144, 244a, 244b, 244c, 244d) stoffschlüssig verbunden ist und die mehreren mikroelektromechanischen Bauelemente (130, 230) auf der Grundplattenvorderseite (160a) angeordnet und deren Bauelementrückseiten (130b) mit der Grundplattenvorderseite (160a) verbunden sind,
wobei die elektrischen Kontakte (144, 244a, 244b, 244c, 244d) zumindest teilweise durch mindestens einen zwischen Grundplatte (160, 260) und ASIC-Schicht (140) angeordneten Schutzrahmen (195, 295) umfasst sind,
wobei die ASIC-Schicht (140) ein oder mehrere ASICs zum Ansteuern der mehreren mikroelektromechanischen Bauelemente (130, 230) aufweist, wobei das eine oder die mehreren ASICs mit den mikroelektromechanischen Bauelementen (130, 230) unter Benutzung zumindest eines Teils der elektrischen Kontakte (144, 244a, 244b, 244c, 244d) elektrisch verbunden sind,
wobei die mehreren MEMS-Module (120, 220) auf der Substratoberfläche (100a, 200a) angeordnet sind und die ASIC-Schicht-Rückseiten (140b) der mehreren MEMS-Module (120, 220) mit der Substratoberfläche (100a, 200a) verbunden sind.

2. Mikroelektromechanische Vorrichtung (110, 210) nach Anspruch **1, dadurch gekennzeichnet, dass** jedes der mehreren mikroelektromechanischen Bauelemente (130, 230) ein Spiegelelement (134, 234) mit einer Reflexionsfläche (136) und eine Verlagerungseinrichtung (132) zum Verlagern des Spiegelelements (134, 234) des jeweiligen mikroelektromechanischen Bauelements (130, 230) umfasst, wobei das eine oder die mehreren ASICs zum Ansteuern der Verlagerungseinrichtungen (132) ausgebildet sind.

3. Mikroelektromechanische Vorrichtung (110, 210) nach einem der vorhergehenden Ansprüche, **dadurch gekennzeichnet, dass** jedes der mehreren MEMS-Module (120, 220) genau 2, 3, 4, 6, 9, 12, 16, 20, 25, 30, 36, 42, 49, 56, 64, 72 oder 81 der mehreren mikroelektromechanischen Bauelemente (130, 230) aufweist.

4. Mikroelektromechanische Vorrichtung (110, 210,) nach einem der vorhergehenden Ansprüche, **dadurch gekennzeichnet, dass** jedes der mehreren mikroelektromechanischen Bauelemente (130, 230) von jedem der mehreren MEMS-Module (120, 220) eine im Wesentlichen rechteckige, vorzugsweise quadratische oder eine im Wesentlichen sechseckige Grundfläche aufweist.

5. Mikroelektromechanische Vorrichtung (110, 210) nach einem der vorhergehenden Ansprüche, **dadurch gekennzeichnet, dass** der mindestens eine Schutzrahmen (195, 295) von jedem der mehreren MEMS-Module (120, 220) ein Teil der stoffschlüssigen Verbindung der Grundplattenrückseite (160b) mit der ASIC-Schicht-Vorderseite (140a) in dem jeweiligen der mehreren MEMS-Module (120, 220) ist.

6. Beleuchtungsoptik für eine Projektionsbelichtungsanlage zur Führung von Beleuchtungsstrahlung zu einem Objektfeld umfassend eine oder mehrere mikroelektromechanische Vorrichtungen (110, 210) nach Anspruch 2 und vorzugsweise einem der Ansprüche 3 bis 5.

7. Beleuchtungssystem für eine Projektionsbelichtungsanlage umfassend eine Beleuchtungsoptik nach Anspruch 6 und eine Strahlungsquelle, vorzugsweise eine EUV-Strahlungsquelle.

8. Projektionsbelichtungsanlage für die Mikrolithographie umfassend eine Beleuchtungsoptik nach Anspruch 6 und eine Projektionsoptik zur Projizierung eines in einem Objektfeld angeordneten Retikels in ein Bildfeld.

9. Verfahren zur Herstellung einer mikroelektromechanischen Vorrichtung (110, 210) vorzugsweise nach einem der Ansprüche 1 bis 5, umfassend ein Trägersubstrat (100, 200) und mehrere MEMS-Module (120, 220), wobei jedes der MEMS-Module (120, 220) eine ASIC-Schicht (140) umfassend ein oder mehrere ASICs mit einer ASIC-Schicht-Vorderseite (140a) und einer ASIC-Schicht-Rückseite (140b), eine Grundplatte (160, 260) mit einer Grundplattenvorderseite (160a) und einer Grundplattenrückseite (160b) und mehrere mikroelektromechanische Bauelemente (130, 230) umfasst, wobei die Grundplatte (160, 260) auf der ASIC-Schicht-Vorderseite (140a) angeordnet und die Grundplattenrückseite (160b) mit der ASIC-Schicht-Vorderseite (140a) verbunden ist, umfassend die folgenden Schritte:
a. Bereitstellen (310) eines MEMS-Substrats mit Strukturen für die mikroelektromechanischen Bauelemente (130, 230) und für die Grundplatten (160, 260) der mehreren MEMS-Module (120, 220);
b. Bereitstellen (320) eines ASIC-Substrats mit Strukturen für die ASIC-Schichten (140) der mehreren MEMS-Module (120, 220);
c. Herstellen (330) eines gekoppelten Substrats durch stoffschlüssiges Verbinden des MEMS-Substrats mit dem ASIC-Substrat, wobei für jedes der mehreren MEMS-Modul (120, 220) mehrere zugeordnete elektrische Kontakte (144, 244a, 244b, 244c, 244d) und mindestens ein zugeordneter Schutzrahmen (195, 295) zwischen MEMS-Substrat und ASIC-Substrat ausgebildet werden, so dass für jedes MEMS-Modul (120, 220) der dem MEMS-Modul (120, 220) mindestens eine zugeordnete Schutzrahmen (195, 295) die dem MEMS-Modul (120, 220) zugeordneten elektrischen Kontakte (144, 244a, 244b, 244c, 244d) zumindest teilweise umfasst;
d. Vereinzeln (340) des gekoppelten Substrats entlang vorgegebener Trennlinien zum Erhalt der mehreren MEMS-Module (120, 220);
e. Bereitstellen (350) des Trägersubstrats (100, 200);
f. Platzieren (360) der mehreren MEMS-Module (120) auf einer Substratoberfläche (100a, 200a) des Trägersubstrats (100, 200); und
g. stoffschlüssiges Verbinden (370) der ASIC-Schicht-Rückseiten (140b) der mehreren MEMS-Module (120, 220) mit der Substratoberfläche (100a, 200a).

10. Verfahren nach Anspruch 9, **dadurch gekennzeichnet, dass**
• vor dem Herstellen (330) des gekoppelten Substrats ein Testen (315) der Strukturen des MEMS-Substrats und/oder ein Testen (325) der Strukturen des ASIC-Substrats erfolgt; und/oder
• nach dem Herstellen (330) des gekoppelten Substrats ein Testen (345) der MEMS-Module (120, 220) erfolgt; und/oder
• nach dem stoffschlüssigen Verbinden (370) der ASIC-Schicht-Rückseiten (140b) der mehreren MEMS-Module (120, 220) mit der Substratoberfläche (100a, 200a) ein Testen (375) der hergestellten mikroelektromechanischen Vorrichtung (110, 210) erfolgt.

## Claims

1. Microelectromechanical device (110, 210) comprising a carrier substrate (100, 200) having a substrate surface (100a, 200a), and a plurality of MEMS modules (120, 220), wherein each of the plurality of MEMS modules (120, 220) comprises an ASIC layer (140) having an ASIC layer front side (140a) and an ASIC layer rear side (140b), a baseplate (160, 260) having a baseplate front side (160a) and a baseplate rear side (160b), and a plurality of microelectromechanical components (130, 230) having a component rear side (130b),
wherein the baseplate (160, 260) is arranged on the ASIC layer front side (140a) and the baseplate rear side (160b) is cohesively connected to the ASIC layer front side (140a) by way of electrical contacts (144, 244a, 244b, 244c, 244d) and the plurality of microelectromechanical components (130, 230) are arranged on the baseplate front side (160a) and their component rear sides (130b) are connected to the baseplate front side (160a),
wherein the electrical contacts (144, 244a, 244b, 244c, 244d) are at least partly encompassed by at least one protective frame (195, 295) arranged between baseplate (160, 260) and ASIC layer (140),
wherein the ASIC layer (140) has one or a plurality of ASICs for controlling the plurality of microelectromechanical components (130, 230), wherein the one or the plurality of ASICs are electrically connected to the microelectromechanical components (130, 230) using at least one portion of the electrical contacts (144, 244a, 244b, 244c, 244d),
wherein the plurality of MEMS modules (120, 220) are arranged on the substrate surface (100a, 200a) and the ASIC layer rear sides (140b) of the plurality of MEMS modules (120, 220) are connected to the substrate surface (100a, 200a).

2. Microelectromechanical device (110, 210) according to Claim 1, **characterized in that** each of the plurality of microelectromechanical components (130, 230) comprises a mirror element (134, 234) having a reflection surface (136), and a displacement unit (132) for displacing the mirror element (134, 234) of the respective microelectromechanical component (130, 230), wherein the one or the plurality of ASICs are configured for controlling the displacement units (132).

3. Microelectromechanical device (110, 210) according to either of the preceding claims, **characterized in that** each of the plurality of MEMS modules (120, 220) has exactly 2, 3, 4, 6, 9, 12, 16, 20, 25, 30, 36, 42, 49, 56, 64, 72 or 81 of the plurality of microelectromechanical components (130, 230).

4. Microelectromechanical device (110, 210) according to any of the preceding claims, **characterized in that** each of the plurality of microelectromechanical components (130, 230) of each of the plurality of MEMS modules (120, 220) has a substantially rectangular, preferably square, base surface or a substantially hexagonal base surface.

5. Microelectromechanical device (110, 210) according to any of the preceding claims, **characterized in that** the at least one protective frame (195, 295) of each of the plurality of MEMS modules (120, 220) is a part of the cohesive connection of the baseplate rear side (160b) to the ASIC layer front side (140a) in the respective one of the plurality of MEMS modules (120, 220).

6. Illumination optical unit for a projection exposure apparatus for guiding illumination radiation to an object field, comprising one or a plurality of microelectromechanical devices (110, 210) according to Claim 2 and preferably any of Claims 3 to 5.

7. Illumination system for a projection exposure apparatus, comprising an illumination optical unit according to Claim 6 and a radiation source, preferably an EUV radiation source.

8. Microlithographic projection exposure apparatus, comprising an illumination optical unit according to Claim 6 and a projection optical unit for projecting a reticle arranged in an object field into an image field.

9. Method for producing a microelectromechanical device (110, 210) preferably according to any of Claims 1 to 5, comprising a carrier substrate (100, 200) and a plurality of MEMS modules (120, 220), wherein each of the MEMS modules (120, 220) comprises an ASIC layer (140) comprising one or a plurality of ASICs having an ASIC layer front side (140a) and an ASIC layer rear side (140b), a baseplate (160, 260) having a baseplate front side (160a) and a baseplate rear side (160b), and a plurality of microelectromechanical components (130, 230), wherein the baseplate (160, 260) is arranged on the ASIC layer front side (140a) and the baseplate rear side (160b) is connected to the ASIC layer front side (140a), comprising the following steps:
a. providing (310) a MEMS substrate having structures for the microelectromechanical components (130, 230) and for the baseplates (160, 260) of the plurality of MEMS modules (120, 220);
b. providing (320) an ASIC substrate having structures for the ASIC layers (140) of the plurality of MEMS modules (120, 220);
c. producing (330) a coupled substrate by cohesively connecting the MEMS substrate to the ASIC substrate, wherein a plurality of assigned electrical contacts (144, 244a, 244b, 244c, 244d) and at least one assigned protective frame (195, 295) between MEMS substrate and ASIC substrate are formed for each of the plurality of MEMS modules (120, 220), such that for each MEMS module (120, 220) the at least one protective frame (195, 295) assigned to the MEMS module (120, 220) at least partly encompasses the electrical contacts (144, 244a, 244b, 244c, 244d) assigned to the MEMS module (120, 220);
d. singulating (340) the coupled substrate along predefined separating lines in order to obtain the plurality of MEMS modules (120, 220);
e. providing (350) the carrier substrate (100, 200);
f. placing (360) the plurality of MEMS modules (120) on a substrate surface (100a, 200a) of the carrier substrate (100, 200); and
g. cohesively connecting (370) the ASIC layer rear sides (140b) of the plurality of MEMS modules (120, 220) to the substrate surface (100a, 200a).

10. Method according to Claim 9, **characterized in that**
• producing (330) the coupled substrate is preceded by testing (315) the structures of the MEMS substrate and/or testing (325) the structures of the ASIC substrate; and/or
• producing (330) the coupled substrate is succeeded by testing (345) the MEMS modules (120, 220); and/or
• cohesively connecting (370) the ASIC layer rear sides (140b) of the plurality of MEMS modules (120, 220) to the substrate surface (100a, 200a) is succeeded by testing (375) the microelectromechanical device (110, 210) produced.

## Revendications

1. Dispositif micro-électromécanique (110, 210) comprenant un substrat de support (100, 200) présentant une surface de substrat (100a, 200a) et une pluralité de modules MEMS (120, 220),
chacun de la pluralité de modules MEMS (120, 220) comprenant une couche d'ASIC (140) avec une face avant de couche d'ASIC (140a) et une face arrière de couche d'ASIC (140b), une plaque de base (160, 260) avec une face avant de plaque de base (160a) et une face arrière de plaque de base (160b) et une pluralité de composants micro-électromécaniques (130, 230) avec une face arrière de composant (130b),
la plaque de base (160, 260) étant disposée sur la face avant de couche d'ASIC (140a), et la face arrière de plaque de base (160b) étant liée par complémentarité de matériau à la face avant de couche d'ASIC (140a) par l'intermédiaire de contacts électriques (144, 244a, 244b, 244c, 244d) et la pluralité de composants micro-électromécaniques (130, 230) étant disposés sur la face avant de plaque de base (160a) et leurs faces arrière de composants (130b) étant reliées à la face avant de plaque de base (160a),
les contacts électriques (144, 244a, 244b, 244c, 244d) étant entourés au moins partiellement par au moins un cadre de protection (195, 295) qui est disposé entre la plaque de base (160, 260) et la couche d'ASIC (140),
la couche d'ASIC (140) comportant un ou plusieurs ASIC pour commander la pluralité de dispositifs micro-électromécaniques (130, 230), le ou les ASIC étant électriquement connectés aux composants micro-électromécaniques (130, 230) en utilisant au moins une partie des contacts électriques (144, 244a, 244b, 244c, 244d),
la pluralité de modules MEMS (120, 220) étant disposés sur la surface de substrat (100a, 200a) et les faces arrière de couche d'ASIC (140b) de la pluralité de modules MEMS (120, 220) étant reliées à la surface de substrat (100a, 200a).

2. Dispositif micro-électromécanique (110, 210) selon la revendication 1, **caractérisé en ce que** chacun de la pluralité de composants micro-électromécaniques (130, 230) comprend un élément miroir (134, 234) présentant une surface réfléchissante (136) et un dispositif de déplacement (132) pour déplacer l'élément miroir (134, 234) du composant micro-électromécanique (130, 230) respectif, le ou les ASIC étant conçus pour commander les dispositifs de déplacement (132).

3. Dispositif micro-électromécanique (110, 210) selon l'une quelconque des revendications précédentes, **caractérisé en ce que** chacun de la pluralité de modules MEMS (120, 220) comporte exactement 2, 3, 4, 6, 9, 12, 16, 20, 25, 30, 36, 42, 49, 56, 64, 72 ou 81 de la pluralité de composants micro-électromécaniques (130, 230) .

4. Dispositif micro-électromécanique (110, 210) selon l'une quelconque des revendications précédentes, **caractérisé en ce que** chacun de la pluralité de composants micro-électromécaniques (130, 230) de chacun de la pluralité de modules MEMS (120, 220) présente une surface de base sensiblement rectangulaire, de préférence carrée ou sensiblement hexagonale.

5. Dispositif micro-électromécanique (110, 210) selon l'une quelconque des revendications précédentes, **caractérisé en ce que** l'au moins un cadre de protection (195, 295) de chacun de la pluralité de modules MEMS (120, 220) fait partie de la liaison par complémentarité de matériau de la face arrière de plaque de base (160b) à la face avant de couche d'ASIC (140a) dans le module respectif de la pluralité de modules MEMS (120, 220).

6. Optique d'éclairage pour un appareil d'exposition par projection destiné à guider un rayonnement d'éclairage vers un champ objet, comprenant un ou plusieurs dispositifs micro-électromécaniques (110, 210) selon la revendication 2 et de préférence l'une quelconque des revendications 3 à 5.

7. Système d'éclairage pour un appareil d'exposition par projection comprenant une optique d'éclairage selon la revendication 6 et une source de rayonnement, de préférence une source de rayonnement EUV.

8. Appareil d'exposition par projection microlithographique comprenant une optique d'éclairage selon la revendication 6 et une optique de projection pour projeter dans un champ image un réticule disposé dans un champ objet.

9. Procédé de production d'un dispositif micro-électromécanique (110, 210), de préférence selon l'une quelconque des revendications 1 à 5, comprenant un substrat de support (100, 200) et une pluralité de modules MEMS (120, 220), chacun des modules MEMS (120, 220) comprenant une couche d'ASIC (140) comprenant un ou plusieurs ASIC avec une face avant de couche d'ASIC (140a) et une face arrière de couche d'ASIC (140b), une plaque de base (160, 260) avec une face avant de plaque de base (160a) et une face arrière de plaque de base (160b) et une pluralité de composants micro-électromécaniques (130, 230), la plaque de base (160, 260) étant disposée sur la face avant de couche d'ASIC (140a) et la face arrière de plaque de base (160b) étant reliée à la face avant de couche d'ASIC (140a), comprenant les étapes suivantes :
a. fourniture (310) d'un substrat MEMS présentant des structures pour les composants micro-électromécaniques (130, 230) et pour les plaques de base (160, 260) de la pluralité de modules MEMS (120, 220) ;
b. fourniture (320) d'un substrat d'ASIC présentant des structures pour les couches d'ASIC (140) de la pluralité de modules MEMS (120, 220) ;
c. production (330) d'un substrat couplé par liaison par complémentarité de matériau du substrat MEMS au substrat d'ASIC, dans lequel, pour chacun de la pluralité de modules MEMS (120, 220), une pluralité de contacts électriques (144, 244a, 244b, 244c, 244d) associés et au moins un cadre de protection (195, 295) associé sont formés entre le substrat MEMS et le substrat d'ASIC, de sorte que pour chaque module MEMS (120, 220), l'au moins un cadre de protection (195, 295) associé au module MEMS (120, 220) comprend au moins partiellement les contacts électriques (144, 244a, 244b, 244c, 244d) associés au module MEMS (120, 220) ;
d. singularisation (340) du substrat couplé le long de lignes de séparation prédéterminées pour obtenir la pluralité de modules MEMS (120, 220) ;
e. fourniture (350) du substrat de support (100, 200) ;
f. mise en place (360) de la pluralité de modules MEMS (120) sur une surface de substrat (100a, 200a) du substrat de support (100, 200) ; et
g. liaison par complémentarité de matériau (370) des faces arrière de couche d'ASIC (140b) de la pluralité de modules MEMS (120, 220) à la surface de substrat (100a, 200a).

10. Procédé selon la revendication 9, **caractérisé en ce que**
• avant la production (330) du substrat couplé, on effectue un test (315) des structures du substrat MEMS et/ou un test (325) des structures du substrat d'ASIC ; et/ou
• après la production (330) du substrat couplé, on effectue un test (345) des modules MEMS (120, 220) ; et/ou
• après la liaison par complémentarité de matériau (370) des faces arrière de couche d'ASIC (140b) de la pluralité de modules MEMS (120, 220) à la surface de substrat (100a, 200a), on effectue un test (375) du dispositif micro-électromécanique (110, 210) produit.
